# EUROPÄISCHE PATENTSCHRIFT

(11) **EP 4 094 550 B1**
(45) Veröffentlichungstag und Bekanntmachung des Hinweises auf die Patenterteilung: **20.08.2025**
(21) Anmeldenummer: 21700271.6
(22) Anmeldetag: 08.01.2021
(51) Int. Cl.: H05K 5/06, H05K 5/02

(54) **GEHÄUSE MIT EINER DRUCKAUSGLEICHSEINRICHTUNG**
HOUSING HAVING A PRESSURE COMPENSATION DEVICE
BOÎTIER DOTÉ D'UN DISPOSITIF DE COMPENSATION DE PRESSION

(30) Priorität: 20.01.2020 DE 102020101213
(43) Veröffentlichungstag der Anmeldung: 30.11.2022
(73) Patentinhaber: KNORR-BREMSE Systeme für Nutzfahrzeuge GmbH, 80809 München (DE)
(72) Erfinder: KARAGÖZ, Hasan-Özkan, 75175 Pforzheim (DE); RÖTHER, Friedbert, 74389 Cleebronn (DE); FRANZKE, Thilo, 96231 Bad Staffelstein (DE)
(86) Internationale Anmeldenummer: PCT/EP2021/050232
(87) Internationale Veröffentlichungsnummer: WO 2021/148256

(56) Entgegenhaltungen:
- EP-B1- 3 385 584
- WO-A1-2016/180972

## Beschreibung

Die Erfindung betrifft ein Gehäuse mit einer Druckausgleichseinrichtung gemäß dem Oberbegriff von Anspruch 1.

Um durch eindringenden Schmutz, Temperaturschwankungen und Kondensfeuchtigkeit verursachte Probleme zu vermeiden, weisen inbesondere korrosionsempfindliche Elektronik und Elektrik aufnehmende Gehäuse oftmals eine Druckausgleichseinrichtung auf.

WO 2016/180972 A1 offenbart eine einstückige Druckausgleichseinrichtung aus einem Elastomer. Die Druckausgkeichseinrichtung ermöglicht die Ableitung von Überdruck nach außen mittels elastischer Lippen.

Ein gattungsbildendes Gehäuse mit einer Druckausgleichseinrichtung ist in EP 3 385 584 B1 offenbart. Dort beinhaltet die Druckausgleichseinrichtung einen gitterförmigen Käfig mit einer Gasdurchtrittsöffnung, welche die Innenseite und die Außenseite der Druckausgleichseinrichtung bedarfsweise strömungsleitend verbindet und welche von einer gaspermeablen Membran überdeckt ist, welche als Vliesstoff-Verbundteil ausgebildet ist und zumindest eine Vliesstofflage umfasst. Der Membran ist ein als Berstschutz ausgebildetes Überdruckventil in einer funktionstechnischen Parallelschaltung zugeordnet, wobei das Überdruckventil einen kreisringförmigen Schirm umfasst, dessen Innenrand zwischen zwei Teilen einer inneren Hälfte des Käfigs geklemmt ist und dessen Außenrand mit einer Dichtfläche am äußeren Rand der inneren Hälfte dichtend zusammenwirkt. Die Gasdurchtrittsöffnung ist zentral in der inneren Hälfte des Käfigs ausgebildet, wobei die innere Hälfte des Käfigs von einer äußeren Hälfte des Käfigs umschlossen wird. Dadurch entsteht ein komplexer Aufbau der Druckausgleichseinrichtung mit einer relativ hohen Anzahl von zu montierenden Bauteilen.

Demgegenüber besteht die Aufgabe der Erfindung darin, ein Gehäuse mit einer Druckausgleichseinrichtung zu schaffen, welche einfacher aufgebaut und kostengünstiger zu fertigen ist.

Diese Aufgabe wird durch eine Druckausgleichseinrichtung gemäß Anspruch 1 gelöst.

### Offenbarung der Erfindung

Die Erfindung geht aus von einem Gehäuse mit einer Druckausgleichseinrichtung zum Ausgleich eines Drucks in einem mit der Druckausgleichseinrichtung in Verbindung stehenden Innenraum des Gehäuses in Bezug auf eine Umgebung des Gehäuses, mit wenigstens folgenden Merkmalen:
a) Die Druckausgleichseinrichtung umfasst wenigstens ein Überdruckventil mit wenigstens einem Lippendichtungselement mit einem Grundkörper und wenigstens einer von einem Außenumfang des Grundkörpers nach radial außen ragenden flexiblen Dichtlippe, welche mit einer Dichtfläche zusammenwirkt,
b) zwischen dem Grundkörper und der Dichtfläche wird ein Ringkanal ausgebildet, wobei die wenigstens eine flexible Dichtlippe in einer Dichtstellung unter elastischer Vorspannung, die Dichtfläche dichtend kontaktiert und damit den Ringkanal zur Verhinderung einer strömungsleitenden Verbindung zwischen dem Innenraum und der Umgebung dichtend verschließt, und in einer Öffnungsstellung von der Dichtfläche abgehoben ist und damit den Ringkanal zur Bereitstellung einer strömungsleitenden Verbindung zwischen dem Innenraum und der Umgebung öffnet,
c) die Stellung der wenigstens einen Dichtlippe zwischen der Dichtstellung und der Öffnungsstellung wird abhängig von einer Druckdifferenz zwischen dem Druck im Innenraum des Gehäuses und der Umgebung des Gehäuses gesteuert,
d) der Grundkörper des Lippendichtungselements weist einen inneren Gasdurchtrittskanal auf, welcher den Innenraum mit der Umgebung bedarfsweise verbindet,
e) die Druckausgleichseinrichtung umfasst wenigstens eine gaspermeable Membran, welche den inneren Gasdurchtrittskanal des Grundkörpers überdeckt,
f) das Überdruckventil und die wenigstens eine Membrane sind in einer funktionstechnischen Parallelschaltung derart angeordnet, dass eine Druckdifferenz zwischen dem Innenraum des Gehäuses und der Umgebung des Gehäuses sowohl auf das Überdruckventil als auch auf die wenigstens eine Membrane wirkt.

Dass die Stellung der wenigstens einen Dichtlippe zwischen der Dichtstellung und der Öffnungsstellung abhängig von einer Druckdifferenz zwischen dem Druck im Innenraum des Gehäuses und der Umgebung des Gehäuses gesteuert wird, bedeutet insbesondere, dass
(i) wenn eine Differenz zwischen dem in dem Innenraum herrschenden Innendruck und dem in der Umgebung herrschenden Außendruck unterhalb eines Druckschwellwerts liegt, die wenigstens eine Dichtlippe die Dichtstellung einnimmt, aber
(ii) wenn die Differenz zwischen dem in dem Innenraum herrschenden Innendruck und dem in der Umgebung herrschenden Außendruck den Druckschwellwert erreicht oder überschritten hat, die wenigstens eine Dichtlippe die Öffnungsstellung einnimmt.

Der Druckschwellwert kann beispielsweise ein Wert innerhalb eines Bereichs, wie beispielsweise 0,4 bar bis 1,2 bar, sein.

Unter einem "Gehäuse" im Sinne der Erfindung ist gerade nicht ein separates Gehäuse der Druckausgleichseinrichtung zu verstehen, wie es beispielsweise durch den gitterförmigen Käfig der EP 3 385 584 B1 gebildet wird. Dort muss der gitterfömige Käfig mit der Druckausgleichseinrichtung erst an oder in einem Gehäuse angeordnet werden. Die Druckausgleichseinrichtung gemäß der Erfindung besitzt demgegenüber kein eigenes oder separates Gehäuse, weil die Bohrung der Gehäusewandung des Gehäuses, welches vorgesehen ist, insbesondere eine elektrische, elektronische oder elektro-pneumatische Einrichtung zu hausen, bereits eine äußere Begrenzung für Druckausgleichseinrichtung darstellt.

Das Überdruckventil bildet insbesondere einen Berstschutz für die wenigstens eine Membrane dergestalt aus, dass bei einem plötzlich auftretenden hohen Innendruck in dem Innenraum des Gehäuses ein schneller Druckausgleich in die Umgebung vornehmlich durch das Überdruckventil erfolgt und dadurch ein Bersten der wenigstens einen Membrane vermieden wird. Die wenigstens eine gasdurchlässige Membrane ermöglicht demgegenüber einen langsameren Druckausgleich. Die wenigstens eine Membrane ist daher zwar gasdurchlässig in beiden Richtungen, aber im Hinblick auf Flüssigkeiten derart semipermeabel, dass Flüssigkeiten die wenigstens eine Membrane nur in einer Richtung, nämlich hier vom Innenraum in Richtung Umgebung passieren können, in umgekehrter Richtung aber nicht. Dies verhindert in vorteilhafter Weise ein Eindringen von Flüssigkeit von der Umgebung in den Innenraum des Gehäuses durch die wenigstens eine Membrane hindurch.

Das Gehäuse gemäß der Erfindung weist dann die folgenden weiteren Merkmale auf:
g) der Grundkörper und die wenigstens eine flexible Dichtlippe des Lippendichtungselements sind aus einem elastomeren Werkstoff einstückig ausgebildet,
h) das Gehäuse weist eine Bohrung in einer Gehäusewandung auf, welche einerseits mit dem Innenraum und andererseits mit der Umgebung des Gehäuses in Verbindung steht oder bringbar ist,
i) das Lippendichtungselement ist direkt in der Bohrung in der Gehäusewandung gehalten und die Dichtfläche, mit welcher die wenigstens eine flexible Dichtlippe zusammenwirkt, wird durch die radial innere Umfangsfläche der Bohrung in der Gehäusewandung gebildet,
j) das Lippendichtungselement ist in der Bohrung mittels eines strömungsdurchlässigen Niederhalterelements gekontert.

Bevorzugt weisen die Bohrung in der Gehäusewandung des Gehäuses, das wenigstens eine Lippendichtungselement, der innere Gasdurchtrittskanal des Grundkörpers sowie die wenigstens eine Membrane einen kreisrunden Querschnitt auf. Weiterhin sind diese Elemente auch bevorzugt koaxial angeordnet.

Weiterhin ist bevorzugt der Außendurchmesser der Dichtlippe etwas größer als der Innendurchmesser der Bohrung, damit eine gewisse Anpresskraft zwischen der Dichtlippe und der Dichtfläche in Form der radial inneren Umfangsfläche der Bohrung in der Dichtstellung entsteht.

Im Gegensatz zu EP 3 385 584 B1 wird daher zum einen kein gitterförmiger Käfig mehr benötigt, welcher die Bestandteile der Druckausgleichseinrichtung trägt. Vielmehr ist das Lippendichtungselement direkt in der Bohrung in der Gehäusewandung des Gehäuses gehalten, welches insbesondere eine elektrische, elektronische oder elektro-pneumatische Einrichtung haust. Weiterhin wird die Dichtfläche, mit welcher die wenigstens eine flexible Dichtlippe zusammenwirkt, dann durch die radial innere Umfangsfläche der Bohrung in der Gehäusewandung gebildet.

Im Gegensatz zu EP 3 385 584 B1 ist daher zum andern das Überdruckventil nicht mehr mehrteilig ausgeführt, sondern der Grundkörper und die wenigstens eine flexible Dichtlippe des Lippendichtungselements sind aus einem elastomeren Werkstoff einstückig ausgebildet. Einstückig ausgebildet bedeutet, dass der Grundkörper und die wenigstens eine flexible Dichtlippe des Lippendichtungselements in einem Fertigungsgang gemeinsam hergestellt werden.

Insgesamt ergibt sich mit der Erfindung eine Konstruktion mit nur wenigen Bauelementen, welche das bereits vorhandene, für den Druckausgleich vorgesehene Gehäuse als direkte Aufnahme für die Druckausgleichseinrichtung nutzt.

Vorzugsweise wird die Bohrung des Gehäuses durch eine Stufenbohrung gebildet, wobei eine einen größeten Bohrungsdurchmesser von einem kleineren Bohrungsdurchmesser trennende Stufe der Stufenbohrung einen axialen Anschlag für das Lippendichtungselement bildet. Der größere Bohrungsdurchmesser der Stufenbohrung ist insbesondere der Seite des Innenraums des Gehäuses zugewandt und der Seite der Umgebung abgewandt angeordnet. Dann kann die wenigstens eine Membrane zwischen dem Lippendichtungselement und der Stufe der Stufenbohrung gehalten oder geklemmt sein.

Alternativ kann die Bohrung des Gehäuses auch durch eine Sacklochbohrung gebildet werden, wobei der Boden der Sacklochbohrung einen axialen Anschlag für das Lippendichtungselement bildet und im Boden der Sacklochbohrung wenigstens eine Öffnung ausgebildet ist, welche eine zur Umgebung weisende Seite des Lippendichtungselements und der wenigstens einen Membrane mit der Umgebung verbindet. Insbesondere kann die Öffnung exzentrisch in Bezug zu einer Mittelachse der Sacklochbohrung angeordnet sein. Die Bohrungsöffnung der Sacklochbohrung ist insbesondere der Seite des Innenraums des Gehäuses zugewandt und der Seite der Umgebung abgewandt angeordnet. Dabei kann die wenigstens eine Membrane zwischen dem Lippendichtungselement und dem Boden der Sacklochbohrung gehalten oder geklemmt sein.

Das Lippendichtungselement ist in der Bohrung mittels eines strömungsdurchlässigen Niederhalterelements gekontert. Dabei kann das Niederhalterelement beispielsweise durch einen Deckel mit wenigstens einer Durchgangsöffnung gebildet werden. Das Niederhalterelement ist insbesondere der Seite des Innenraums des Gehäuses zugewandt und der Seite der. Umgebung abgewandt angeordnet. Dann kann die wenigstens eine Membrane zwischen dem Lippendichtungselement und dem Niederhalterelement gehalten oder geklemmt sein.

Auch kann das Lippendichtungselement axial in wenigstens zwei Lippendichtungselement-Teile geteilt sein, und die wenigstens eine Membrane dann zwischen den beiden Lippendichtungselement-Teilen axial geklemmt oder gehalten sein.

Gemäß einer Weiterbildung kann die wenigstens eine Membrane in das Lippendichtungselement bereits bei der Herstellung des Lippendichtungselements aus dem elastomeren Material einvulkanisiert sein. Dabei kann insbesonderee ein radial äußerer Rand der wenigstens einen Membrane in das aus dem elastomeren Werkstoff bestehende Lippendichtungselement einvulkanisiert sein.

Weiterhin kann die wenigstens eine Membrane mit dem Lippendichtungselement unlösbar, d.h. nicht ohne Zerstörung lösbar oder lösbar verbunden sein. Insbesondere kann die wenigstens eine Membrane einen radial äußeren Trägerring aufweisen, welcher mit dem Lippendichtungselement unlösbar oder lösbar verbunden ist.

Beispielsweise kann die wenigstens eine Membrane mit dem Lippendichtungselement durch Klebung verbunden sein.

Gemäß einer Weiterbildung kann die wenigstens eine Membrane aus wenigstens einer Membranlage bestehen, oder durch ein Verbundteil aus wenigstens einer Membranlage und wenigstens einer Vliesstofflage gebildet werden. Dabei kann die wenigstens eine Membranlage beispielsweise aus Polytetrafluorethylen (PTFE) oder aus Polyvinylidenfluorid (PVDF) bestehen.

Auch kann die wenigstens eine flexible Dichtlippe des Lippendichtungselements an dem Grundkörper in Umfangsrichtung gesehen umlaufend ausgebildet sein.

Bevorzugt ist das Überdruckventil ausgebildet, dass es zwar eine Strömung von dem Innnenraum in die Umgebung gestattet, aber eine eine Strömung von der Umgebung in den Innenraum hinein verhindert. Dadurch wird bei dem Überdruckventil ein Eintrag von Feuchtigkeit und Schmutz aus der Umgebung in den Innenraum des Gehäuses vermieden.

Dies kann beispielsweise dadurch realisiert sein, dass die wenigstens eine flexible Dichtlippe des Lippendichtungselements vom Grundkörper in einem spitzen Winkel in Richtung Umgebung wegragt. Dann sorgt ein umgebungsseitiger Überdruck dafür, dass die Dichtlippe stärker gegen die radial innere Umfangsfläche der Bohrung gepresst und die Dichtwirkung in dieser Richtung dann erhöht wird.

Bevorzugt ist das Gehäuse das Gehäuse einer elektronischen oder elektro-pneumatischen Einrichtung eines Fahrzeugs, insbesondere eines elektro-pneumatischen Druckregelmoduls oder elektro-pneumatischen Achsmodulators einer elektro-pneumatischen elektronisch geregelten Bremseinrichtung eines Fahrzeugs.

Ausführungsbeispiele der Erfindung werden in der nachfolgenden Beschreibung mit Bezug zu den Figuren näher erläutert. Es zeigen:
- Fig. 1: eine perspektivische aufgeschnittene Darstellung eines Gehäuses eines elektro-pneumatischen Druckregelmodul als bevorzugte Ausführung eines Gehäuses gemäß der Erfindung;
- Fig. 2: eine schematische Querschnittsdarstellung des Gehäuses von Fig. 1;
- Fig. 3: einen vergrößerten Ausschnitt aus Fig. 2.

### Beschreibung der Ausführungsbeispiele

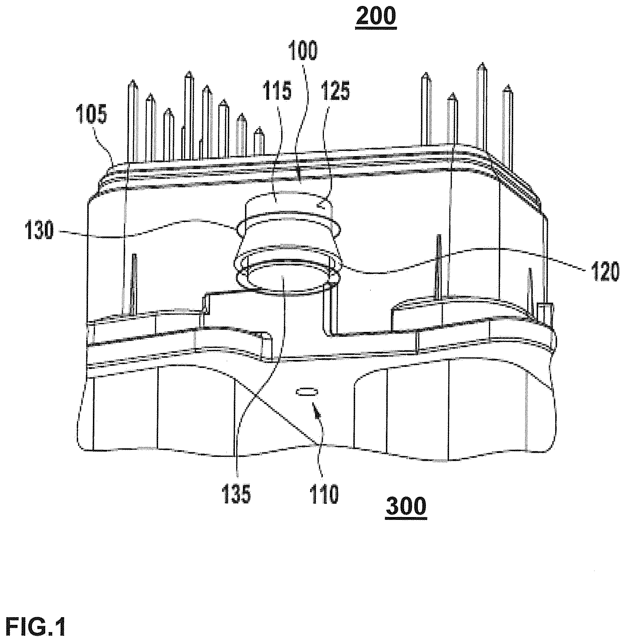

**Fig. 1** zeigt eine perspektivische aufgeschnittene Darstellung eines Gehäuses 105 eines elektro-pneumatischen Druckregelmoduls einer elektro-pneumatischen Bremseinrichtung eines Fahrzeugs als bevorzugte Ausführung eines Gehäuses gemäß der Erfindung.

Das Gehäuse 105 weist eine Druckausgleichseinrichtung 100 auf bzw. in das Gehäuse 105 ist eine Druckausgleichseinrichtung 100 integriert, welche zum Druckausgleich zwischen einem Innendruck in einem mit der Druckausgleichseinrichtung 100 in Verbindung stehenden Innenraum 200 des Gehäuses 105 und einem in der Umgebung 300 des Gehäuses 2015 herrschenden Außendruck dient, welcher in der Regel dem Atmosphärendruck entspricht.

Die Druckausgleichseinrichtung 100 umfasst ein Überdruckventil mit einem Lippendichtungselement 115, welche im Wesentlichen aus einem Grundkörper 125 und hier beispielsweise einer von einem Außenumfang des Grundkörpers 125 nach radial außen ragenden flexiblen Dichtlippe 120 besteht. Der Grundkörper 125 und die flexible Dichtlippe 120 des Lippendichtungselements 115 sind aus einem elastomeren Werkstoff einstückig ausgebildet.

Die flexible Dichtlippe 120 des Lippendichtungselements 115 wirkt mit einer Dichtfläche 140 zusammen, welche durch eine radial innere Umfangsfläche einer Bohrung 205 in einer Gehäusewandung des Gehäuses 105 gebildet wird. Die rührt daher, weil das Lippendichtungselement 115 direkt in der Bohrung 205 der Gehäusewandung gehalten ist. Die Bohrung 205 steht einerseits mit dem Innenraum 200 und andererseits mit der Umgebung 300 des Gehäuses 105 in Verbindung.

Zwischen dem Grundkörper 125 und der Dichtfläche 140 bzw. der radial inneren Umfangsfläche der Bohrung 205 wird ein Ringkanal 130 ausgebildet, wobei die flexible Dichtlippe 120 in einer Dichtstellung des Überdruckventils unter elastischer Vorspannung die Dichtfläche 140 dichtend kontaktiert und damit den Ringkanal 130 zur Verhinderung einer strömungsleitenden Verbindung zwischen dem Innenraum 200 und der Umgebung 300 dichtend verschließt. In einer Öffnungsstellung des Überdruckventils ist hingegen die flexible Dichtlippe 120 von der Dichtfläche 140 abgehoben. Damit wird der Ringkanal 130 zur Bereitstellung einer strömungsleitenden Verbindung zwischen dem Innenraum 200 und der Umgebung 300 geöffnet.

Bevorzugt ist der Außendurchmesser der Dichtlippe 120 etwas größer als der Innendurchmesser der Bohrung 205, damit eine gewisse Anpresskraft zwischen der Dichtlippe 120 und der Dichtfläche 140 in Form der radial inneren Umfangsfläche der Bohrung 205 in der Dichtstellung entsteht. Die flexible Dichtlippe 120 des Lippendichtungselements 115 ist an dem Grundkörper 125 in Umfangsrichtung gesehen bevorzugt umlaufend ausgebildet.

Die Stellung der flexiblen Dichtlippe 120 zwischen der Dichtstellung und der Öffnungsstellung wird abhängig von einer Druckdifferenz zwischen dem Innendruck im Innenraum 200 des Gehäuses 105 und dem in der Umgebung 300 des Gehäuses 105 herrschenden Außendruck gesteuert. Dies bedeutet beispielsweise, dass wenn eine Differenz zwischen dem in dem Innenraum 200 herrschenden Innendruck und dem in der Umgebung 300 herrschenden Außendruck (Atmosphärendruck) unterhalb eines Druckschwellwerts liegt, dann nimmt die flexible Dichtlippe 120 die Dichtstellung ein. Wenn aber die Differenz zwischen dem Innendruck und dem Außendruck den Druckschwellwert erreicht oder überschritten hat, so nimmt die flexible Dichtlippe 120 die Öffnungsstellung ein. Der Druckschwellwert kann beispielsweise ein Wert innerhalb eines Bereichs, wie beispielsweise 0,4 bar bis 1,2 bar, sein.

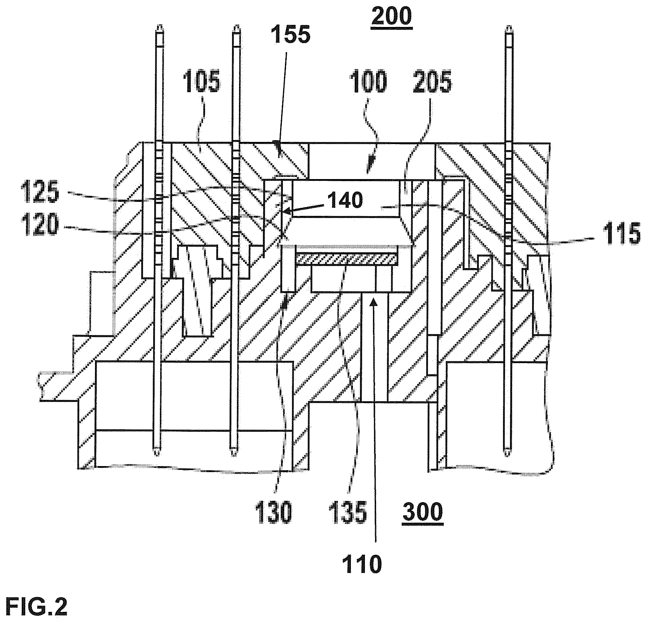

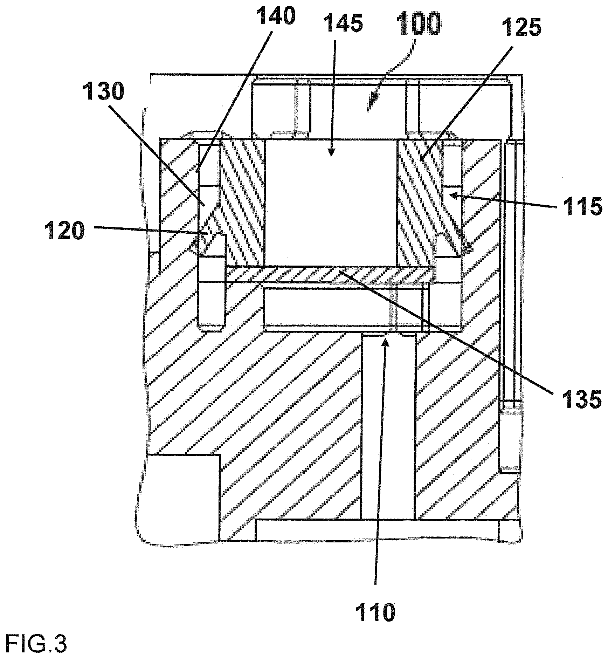

Bevorzugt ist das Überdruckventil ausgebildet, dass es zwar eine Strömung von dem Innnenraum 200 in die Umgebung 300 gestattet, aber eine eine Strömung von der Umgebung 300 in den Innenraum 200 hinein verhindert. Dadurch wird bei dem Überdruckventil ein Eintrag von Feuchtigkeit und Schmutz aus der Umgebung 300 in den Innenraum 200 des Gehäuses 105 vermieden. Dies ist hier beispielsweise dadurch realisiert sein, dass die flexible Dichtlippe 120 des Lippendichtungselements 115 vom Grundkörper 125 in einem spitzen Winkel in Richtung Umgebung 300 wegragt, wie **Fig. 2** und **Fig. 3** veranschaulichen. Dann sorgt ein umgebungsseitiger Überdruck, d.h. ein gegenüber dem Innendruck höherer Außendruck dafür, dass die flexible Dichtlippe 120 stärker gegen die Dichtfläche 140 gepresst und die Dichtwirkung somit erhöht wird, wie anhand von **Fig. 2** und **Fig. 3** leicht vorstellbar ist.

Der Grundkörper 125 des Lippendichtungselements 115 weist einen inneren, beispielsweise zentralen Gasdurchtrittskanal 145 auf, welcher den Innenraum 200 mit der Umgebung 300 bedarfsweise verbindet. Weiterhin umfasst die Druckausgleichseinrichtung 100 eine gaspermeable Membrane 135, welche den inneren Gasdurchtrittskanal 145 des Grundkörpers 125 überdeckt.

Bevorzugt weisen die Bohrung 205 in der Gehäusewandung des Gehäuses 105, das Lippendichtungselement 115, der innere Gasdurchtrittskanal 145 des Grundkörpers 125 sowie die Membrane 135 jeweils einen kreisrunden Querschnitt, wobei diese Elemente auch bevorzugt koaxial angeordnet sind.

Das Überdruckventil, d.h. das mit der Bohrung 205 zusammenwirkende Lippendichtungselement 115 und die Membrane 135 sind in einer funktionstechnischen Parallelschaltung angeordnet. Dies bedeutet, dass eine Druckdifferenz zwischen dem Innendruck in dem Innenraum 200 des Gehäuses 105 und dem Außendruck in der Umgebung 300 des Gehäuses 105 sowohl auf das Überdruckventil als auch auf die Membrane 135 wirkt.

Das Überdruckventil bildet insbesondere einen Berstschutz für die Membrane 135 dergestalt aus, dass bei einem plötzlich auftretenden hohen Innendruck in dem Innenraum 200 des Gehäuses 105 ein schneller Druckausgleich in die Umgebung 300 vornehmlich durch das Überdruckventil erfolgt und dadurch ein Bersten der Membrane 135 vermieden wird. Die gasdurchlässige Membrane 135 ermöglicht demgegenüber einen langsameren Druckausgleich. Die Membrane 135 ist daher zwar gasdurchlässig in beiden Richtungen (Innenraum -> Umgebung, Umgebung -> Innenraum), aber im Hinblick auf Flüssigkeiten bevorzugt derart semipermeabel, dass Flüssigkeiten die Membrane 135 nur in einer Richtung, nämlich hier vom Innenraum 200 in Richtung Umgebung 300 passieren können, in umgekehrter Richtung aber nicht.

Bei der In den **Figuren 1 bis 3** gezeigten bevorzugten Ausführungsform wird die Bohrung 205 bevorzugt durch eine Sacklochbohrung gebildet, wobei der Boden 150 der Sacklochbohrung einen axialen Anschlag für das Lippendichtungselement 115 bzw. für dessen Grundkörper 125 bildet. Im Boden 150 der Sacklochbohrung ist dann eine bevorzugt exzentrische Öffnung 110 ausgebildet, welche eine zur Umgebung 300 weisende Seite des Lippendichtungselements 115 oder des Reingkanals 130 und der Membrane 135 mit der Umgebung 300 verbindet. Die Bohrungsöffnung der bevorzugt als Sacklochbohrung ausgeführten Bohrung 205 ist insbesondere der Seite des Innenraums 200 des Gehäuses 105 zugewandt und der Seite der Umgebung 300 abgewandt angeordnet. Dabei ist hier Membrane 135 beispielsweise zwischen dem Lippendichtungselement 115 und dem Boden 150 der als Sacklochbohrung ausgeführten Bohrung 205 geklemmt.

Die Klemmung der Membrane 135 in der Bohrung 205 kann beispielsweise dadurch zustande kommen, dass das Lippendichtungselement 115 in der Bohrung 205 mittels eines strömungsdurchlässigen Niederhalterelements 155 gekontert ist. Dabei kann das Niederhalterelement 155 beispielsweise durch einen Deckel mit hier beispielsweise einer Durchgangsöffnung gebildet werden, damit eine Strömungsverbindung zwischen dem Innenraum 200 und dem Überdruckventil und der Membrane 135 zustande kommen kann. Das Niederhalterelement 155 für das axiale Fixieren des Lippendichtungselements 115 in der Bohrung 205 ist daher hier beispielsweise der Seite des Innenraums 200 des Gehäuses 105 zugewandt und der Seite der Umgebung 300 abgewandt angeordnet.

Alternativ könnte die Bohrung 205 beispielsweise auch durch eine Stufenbohrung gebildet werden, wobei eine einen größeren Bohrungsdurchmesser von einem kleineren Bohrungsdurchmesser der Stufenbohrung trennende Stufe dann beispielsweise einen axialen Anschlag für das Lippendichtungselement 115 bildet. Der größere Bohrungsdurchmesser der Stufenbohrung ist dann beispielsweise der Seite des Innenraums 200 des Gehäuses 105 zugewandt und der Seite der Umgebung 300 abgewandt angeordnet. Dann kann die Membrane 135 beispielsweise zwischen dem Lippendichtungselement 115 und der Stufe der Stufenbohrung gehalten oder geklemmt sein.

Auch kann das Lippendichtungselement 115 axial in wenigstens zwei Lippendichtungselement-Teile geteilt sein, und die Membrane 135 dann zwischen den beiden Lippendichtungselement-Teilen axial geklemmt oder gehalten sein.

Gemäß einer weiteren Ausführungsform kann die Membrane 135 auch in das Lippendichtungselement 115 bereits bei der Herstellung des Lippendichtungselements 115 aus dem elastomeren Material einvulkanisiert sein. Dabei kann insbesonderee ein radial äußerer Rand der Membrane 135 in das aus dem elastomeren Werkstoff bestehende Lippendichtungselement 115 einvulkanisiert werden.

Weiterhin kann die Membrane 135 mit dem Lippendichtungselement 115 unlösbar, d.h. nicht ohne Zerstörung lösbar oder lösbar verbunden sein. Beispielsweise kann die Membrane 135 mit dem Lippendichtungselement 115 durch Klebung verbunden sein. Insbesondere kann die Membrane 135 auch einen radial äußeren Trägerring aufweisen, welcher dasnn mit dem Lippendichtungselement 115 unlösbar oder lösbar verbunden ist.

Bevorzugt besteht die Membrane 135 aus wenigstens einer Membranlage. Dies umfasst genau eine Membranlage oder mehrere Membranlagen, wobei unter einer "Lage" eine separate Schicht zu verstehen ist. Alternativ kann die Membrane 135 auch durch ein Verbundteil aus wenigstens einer Membranlage und wenigstens einer Vliesstofflage gebildet werden. Dabei kann die wenigstens eine Membranlage beispielsweise aus Polytetrafluorethylen (PTFE) oder aus Polyvinylidenfluorid (PVDF) bestehen.

### BEZUGSZEICHENLISTE

- 100: Druckausgleichseinrichtung
- 105: Gehäuse
- 110: Öffnung
- 115: Lippendichtungselement
- 120: Dichtlippe
- 125: Grundkörper
- 130: Ringkanal
- 135: Membrane
- 140: Dichtfläche
- 145: Gasdurchtrittskanal
- 150: Boden
- 155: Deckel

- 200: Innenraum
- 205: Bohrung

- 300: Umgebung

## Patentansprüche

1. Gehäuse (105) mit einer Druckausgleichseinrichtung (100) zum Ausgleich eines Drucks in einem mit der Druckausgleichseinrichtung (100) in Verbindung stehenden Innenraum (200) des Gehäuses (105) in Bezug auf eine Umgebung (300) des Gehäuses (105), mit wenigstens folgenden Merkmalen:
a) die Druckausgleichseinrichtung (100) umfasst wenigstens ein Überdruckventil mit wenigstens einem Lippendichtungselement (115) mit einem Grundkörper (125) und wenigstens einer von einem Außenumfang des Grundkörpers (125) nach radial außen ragenden flexiblen Dichtlippe (120), welche mit einer Dichtfläche (140) zusammenwirkt,
b) zwischen dem Grundkörper (125) und der Dichtfläche (140) wird ein Ringkanal (130) ausgebildet, wobei die wenigstens eine flexible Dichtlippe (120) in einer Dichtstellung unter elastischer Vorspannung die Dichtfläche (140) dichtend kontaktiert und damit den Ringkanal (130) zur Verhinderung einer strömungsleitenden Verbindung zwischen dem Innenraum (200) und der Umgebung (300) dichtend verschließt, und in einer Öffnungsstellung von der Dichtfläche (140) abgehoben ist und damit den Ringkanal (130) zur Bereitstellung einer strömungsleitenden Verbindung zwischen dem Innenraum (200) und der Umgebung (300) öffnet,
c) die Stellung der wenigstens einen Dichtlippe (120) zwischen der Dichtstellung und der Öffnungsstellung wird abhängig von einer Druckdifferenz zwischen dem Druck im Innenraum (200) des Gehäuses und der Umgebung (300) des Gehäuses (105) gesteuert,
d) der Grundkörper (125) des Lippendichtungselements (115) weist einen inneren Gasdurchtrittskanal (145) auf, welcher den Innenraum (200) mit der Umgebung (300) bedarfsweise verbindet,
e) die Druckausgleichseinrichtung (100) umfasst wenigstens eine gaspermeable Membran (135), welche den inneren Gasdurchtrittskanal (145) des Grundkörpers (125) überdeckt,
f) das Überdruckventil und die wenigstens eine Membrane (135) sind in einer funktionstechnischen Parallelschaltung derart angeordnet, dass eine Druckdifferenz zwischen dem Innenraum (200) des Gehäuses und der Umgebung (300) des Gehäuses (105) sowohl auf das Überdruckventil als auch auf die wenigstens eine Membrane (135) wirkt, **gekennzeichnet durch** wenigstens die folgenden Merkmale:
g) der Grundkörper (125) und die wenigstens eine flexible Dichtlippe (120) des Lippendichtungselements (115) sind aus einem elastomeren Werkstoff einstückig ausgebildet,
h) das Gehäuse (105) weist eine Bohrung (205) in einer Gehäusewandung auf, welche einerseits mit dem Innenraum (200) und andererseits mit der Umgebung (300) des Gehäuses (105) in Verbindung steht oder bringbar ist,
i) das Lippendichtungselement (115) ist direkt in der Bohrung (205) in der Gehäusewandung gehalten und die Dichtfläche (140), mit welcher die wenigstens eine flexible Dichtlippe (120) zusammenwirkt, wird durch die radial innere Umfangsfläche der Bohrung (205) in der Gehäusewandung gebildet,
j) das Lippendichtungselement (115) ist in der Bohrung (205) mittels eines strömungsdurchlässigen Niederhalterelements (155) gekontert.

2. Gehäuse nach Anspruch 1, **dadurch gekennzeichnet, dass** die Bohrung (205) des Gehäuses (105) durch eine Stufenbohrung gebildet wird und eine Stufe der Stufenbohrung einen axialen Anschlag für das Lippendichtungselement (115) bildet.

3. Gehäuse nach Anspruch 2, **dadurch gekennzeichnet, dass** die wenigstens eine Membrane (135) zwischen dem Lippendichtungselement (115) und der Stufe der Stufenbohrung gehalten oder geklemmt ist.

4. Gehäuse nach Anspruch 1, **dadurch gekennzeichnet, dass** die Bohrung (205) des Gehäuses (105) durch eine Sacklochbohrung gebildet wird, wobei der Boden (150) der Sacklochbohrung einen axialen Anschlag für das Lippendichtungselement (115) bildet und im Boden (150) der Sacklochbohrung wenigstens eine Öffnung (110) ausgebildet ist, welche eine zur Umgebung weisende Seite des Lippendichtungselements (115) und der wenigstens einen Membrane (135) mit der Umgebung verbindet.

5. Gehäuse nach Anspruch 4, **dadurch gekennzeichnet, dass** die wenigstens eine Membrane (135) zwischen dem Lippendichtungselement (115) und dem Boden (150) der Sacklochbohrung gehalten oder geklemmt ist.

6. Gehäuse nach einem der vorhergehenden Ansprüche, **dadurch gekennzeichnet, dass** die wenigstens eine Membrane (135) zwischen dem Lippendichtungselement (115) und dem Niederhalterelement (155) gehalten oder geklemmt ist.

7. Gehäuse nach einem der vorhergehenden Ansprüche, **dadurch gekennzeichnet, dass** das Lippendichtungselement (115) axial in wenigstens zwei Lippendichtungselement-Teile geteilt ist, und die wenigstens eine Membrane (135) zwischen den beiden Lippendichtungselement-Teilen axial geklemmt ist.

8. Gehäuse nach einem der vorhergehenden Ansprüche, **dadurch gekennzeichnet, dass** die wenigstens eine Membrane (135) mit dem Lippendichtungselement (115) unlösbar oder lösbar verbunden ist.

9. Gehäuse nach einem der Anspruch 8, **dadurch gekennzeichnet, dass** die wenigstens eine Membrane (135) einen radial äußeren Trägerring aufweist, welcher mit dem Lippendichtungselement unlösbar oder lösbar verbunden ist.

10. Gehäuse nach Anspruch 8 oder 9, **dadurch gekennzeichnet, dass** wenigstens ein radial äußerer Rand der wenigstens einen Membrane (135) in das aus dem elastomeren Werkstoff bestehende Lippendichtungselement (115) einvulkanisiert ist.

11. Gehäuse nach Anspruch 8 oder 9, **dadurch gekennzeichnet, dass** die wenigstens eine Membrane (135) mit dem Lippendichtungselement (115) durch Klebung verbunden ist.

12. Gehäuse nach einem der vorhergehenden Ansprüche, **dadurch gekennzeichnet, dass** die wenigstens eine Membrane (135) aus wenigstens einer Membranlage besteht oder durch ein Verbundteil aus wenigstens einer Membranlage und wenigstens einer Vliesstofflage gebildet wird.

13. Gehäuse nach Anspruch 12, **dadurch gekennzeichnet, dass** die wenigstens eine Membranlage aus Polytetrafluorethylen (PTFE) oder aus Polyvinylidenfluorid (PVDF) besteht.

14. Gehäuse nach einem der vorhergehenden Ansprüche, **dadurch gekennzeichnet, dass** die wenigstens eine flexible Dichtlippe des Lippendichtungselements (115) an dem Grundkörper umlaufend ausgebildet ist.

15. Gehäuse nach einem der vorhergehenden Ansprüche, **dadurch gekennzeichnet, dass** das Überdruckventil ausgebildet ist, dass es zwar eine Strömung von dem Innnenraum (200) in die Umgebung (300) gestattet, aber eine eine Strömung von der Umgebung (300) in den Innenraum (200) verhindert.

16. Gehäuse nach Anspruch 15, **dadurch gekennzeichnet, dass** die wenigstens eine flexible Dichtlippe des Lippendichtungselements (115) vom Grundkörper (125) in einem spitzen Winkel in Richtung Umgebung (300) wegragt.

17. Gehäuse nach einem der vorhergehenden Ansprüche, **dadurch gekennzeichnet, dass** es das Gehäuse einer elektronischen oder elektro-pneumatischen Einrichtung eines Fahrzeugs ist.

## Claims

1. Housing (105) having a pressure compensation device (100) for compensating a pressure in an interior (200) of the housing (105) in connection with the pressure compensation device (100) in relation to surroundings (300) of the housing (105), with at least the following features:
a) the pressure compensation device (100) comprises at least one overpressure valve with at least one lip sealing element (115) having a main part (125) and at least one flexible sealing lip (120) which protrudes radially outwardly from an outer circumference of the main part (125) and which interacts with a sealing surface (140),
b) an annular channel (130) is formed between the main part (125) and the sealing surface (140), wherein the at least one flexible sealing lip (120), in a sealing position under elastic pretensioning, sealingly contacts the sealing surface (140) and thus sealingly closes the annular channel (130) to prevent a flow-conducting connection between the interior (200) and the surroundings (300), and is lifted away from the sealing surface (140) in an open position and thus opens the annular channel (130) to provide a flow-conducting connection between the interior (200) and the surroundings (300),
c) the position of the at least one sealing lip (120) between the sealing position and the open position is controlled as a function of a pressure difference between the pressure in the interior (200) of the housing and the surroundings (300) of the housing (105),
d) the main part (125) of the lip sealing element (115) has an inner gas through-channel (145) which connects the interior (200) to the surroundings (300) as required,
e) the pressure compensation device (100) comprises at least one gaspermeable membrane (135) which covers the inner gas through-channel (145) of the main part (125),
f) the overpressure valve and the at least one membrane (135) are arranged in a parallel connection such that a pressure difference between the interior (200) of the housing and the surroundings (300) of the housing (105) acts both on the overpressure valve and on the at least one membrane (135), **characterized by** at least the following features:
g) the main part (125) and the at least one flexible sealing lip (120) of the lip sealing element (115) are configured in a single piece from an elastomer material,
h) the housing (105) has a bore (205) in a housing wall which is in connection or may be brought into connection, on the one hand, with the interior (200) and, on the other hand, with the surroundings (300) of the housing (105),
i) the lip sealing element (115) is directly held in the bore (205) in the housing wall, and the sealing surface (140), with which the at least one flexible sealing lip (120) interacts, is formed by the radially inner circumferential surface of the bore (205) in the housing wall,
j) the lip sealing element (115) is fixed in the bore (205) by means of a flow-permeable hold-down element (155).

2. Housing according to claim 1, **characterized in that** the bore (205) of the housing (105) is formed by a stepped bore and a step of the stepped bore forms an axial stop for the lip sealing element (115).

3. Housing according to claim 2, **characterized in that** the at least one membrane (135) is held or clamped between the lip sealing element (115) and the step of the stepped bore.

4. Housing according to claim 1, **characterized in that** the bore (205) of the housing (105) is formed by a blind bore, wherein the base (150) of the blind bore forms an axial stop for the lip sealing element (115) and at least one opening (110) is configured in the base (150) of the blind bore, the opening connecting to the surroundings a side of the lip sealing element (115) and of the at least one membrane (135) facing toward the surroundings.

5. Housing according to claim 4, **characterized in that** the at least one membrane (135) is held or clamped between the lip sealing element (115) and the base (150) of the blind bore.

6. Housing according to any one of the preceding claims, **characterized in that** the at least one membrane (135) is held or clamped between the lip sealing element (115) and the hold-down element (155).

7. Housing according to any one of the preceding claims, **characterized in that** the lip sealing element (115) is divided axially into at least two lip sealing element parts, and the at least one membrane (135) is axially clamped between the two lip sealing element parts.

8. Housing according to any one of the preceding claims, **characterized in that** the at least one membrane (135) is unreleasably or releasably connected to the lip sealing element (115).

9. Housing according to any one of claim 8, **characterized in that** the at least one membrane (135) has a radially outer carrier ring which is unreleasably or releasably connected to the lip sealing element.

10. Housing according to claim 8 or 9, **characterized in that** at least one radially outer edge of the at least one membrane (135) is vulcanized into the lip sealing element (115) consisting of the elastomer material.

11. Housing according to claim 8 or 9, **characterized in that** the at least one membrane (135) is connected to the lip sealing element (115) by adhesive bonding.

12. Housing according to any one of the preceding claims, **characterized in that** the at least one membrane (135) consists of at least one membrane layer or is formed by a composite part composed of at least one membrane layer and at least one non-woven layer.

13. Housing according to claim 12, **characterized in that** the at least one membrane layer consists of polytetrafluorethylene (PTFE) or polyvinylidene fluoride (PVDF).

14. Housing according to any one of the preceding claims, **characterized in that** the at least one flexible sealing lip of the lip sealing element (115) is configured over the circumference on the main part.

15. Housing according to any one of the preceding claims, **characterized in that** the overpressure valve is configured to permit a flow from the interior (200) into the surroundings (300) but prevent a flow from the surroundings (300) into the interior (200).

16. Housing according to claim 15, **characterized in that** the at least one flexible sealing lip of the lip sealing element (115) protrudes away from the main part (125) at an acute angle in the direction of the surroundings (300).

17. Housing according to any one of the preceding claims, **characterized in that** the housing is for an electronic or electro-pneumatic device of a vehicle.

## Revendications

1. Boîtier (105) avec un dispositif de compensation de pression (100) pour la compensation d'une pression dans un espace intérieur (200) se trouvant en liaison avec le dispositif de compensation de pression (100) du boîtier (105) en ce qui concerne un environnement (300) du boîtier (105), avec au moins les caractéristiques suivantes :
a) le dispositif de compensation de pression (100) comprend au moins une soupape de décharge avec au moins un élément d'étanchéité à lèvres (115) avec un corps de base (125) et au moins une lèvre d'étanchéité (120) flexible dépassant radialement vers l'extérieur d'une périphérie extérieure du corps de base (125), lèvre qui coagit avec une surface d'étanchéité (140),
b) un canal annulaire (130) est formé entre le corps de base (125) et la surface d'étanchéité (140), dans lequel l'au moins une lèvre d'étanchéité (120) flexible est en contact étanche avec la surface d'étanchéité (140) dans une position d'étanchéité sous précontrainte élastique et ainsi ferme le canal annulaire (130) de manière étanche pour l'empêchement d'une liaison conductrice d'écoulement entre l'espace intérieur (200) et l'environnement (300), et est relevé de la surface d'étanchéité (140) dans une position d'ouverture et ainsi ouvre le canal annulaire (130) pour la fourniture d'une liaison conductrice d'écoulement entre l'espace intérieur (200) et l'environnement (300),
c) la position de l'au moins une lèvre d'étanchéité (120) entre la position d'étanchéité et la position d'ouverture est commandée en fonction d'une différence de pression entre la pression dans l'espace intérieur (200) du boîtier et l'environnement (300) du boîtier (105),
d) le corps de base (125) de l'élément d'étanchéité à lèvres (115) présente un canal de passage de gaz (145) intérieur qui relie l'espace intérieur (200) à l'environnement (300) si besoin,
e) le dispositif de compensation de pression (100) comprend au moins une membrane (135) perméable aux gaz qui recouvre le canal de passage de gaz (145) intérieur du corps de base (125),
f) la soupape de décharge et l'au moins une membrane (135) sont agencées dans un circuit parallèle fonctionnel de telle manière qu'une différence de pression entre l'espace intérieur (200) du boîtier et l'environnement (300) du boîtier (105) agisse non seulement sur la soupape de décharge mais aussi sur l'au moins une membrane (135), **caractérisé par** au moins les caractéristiques suivantes :
g) le corps de base (125) et l'au moins une lèvre d'étanchéité (120) flexible de l'élément d'étanchéité à lèvres (115) sont formés en un matériau élastomère d'un seul tenant,
h) le boîtier (105) présente un alésage (205) dans une paroi de boîtier qui est ou peut être amené en liaison d'une part avec l'espace intérieur (200) et d'autre part avec l'environnement (300) du boîtier (105),
i) l'élément d'étanchéité à lèvres (115) est maintenu directement dans l'alésage (205) dans la paroi de boîtier et la surface d'étanchéité (140), avec laquelle l'au moins une lèvre d'étanchéité (120) flexible coagit, est formée par la surface périphérique radialement intérieure de l'alésage (205) dans la paroi de boîtier,
j) l'élément d'étanchéité à lèvres (115) est bloqué par contre-écrou dans l'alésage (205) au moyen d'un élément de retenue (155) perméable à l'écoulement.

2. Boîtier selon la revendication 1, **caractérisé en ce que** l'alésage (205) du boîtier (105) est formé par un alésage étagé et un étage de l'alésage étagé forme une butée axiale pour l'élément d'étanchéité à lèvres (115).

3. Boîtier selon la revendication 2, **caractérisé en ce que** l'au moins une membrane (135) est maintenue ou serrée entre l'élément d'étanchéité à lèvres (115) et l'étage de l'alésage étagé.

4. Boîtier selon la revendication 1, **caractérisé en ce que** l'alésage (205) du boîtier (105) est formé par un alésage de trou borgne, dans lequel le fond (150) de l'alésage de trou borgne forme une butée axiale pour l'élément d'étanchéité à lèvres (115) et au moins une ouverture (110) est formée dans le fond (150) de l'alésage de trou borgne, ouverture qui relie un côté tourné vers l'environnement de l'élément d'étanchéité à lèvres (115) et de l'au moins une membrane (135) à l'environnement.

5. Boîtier selon la revendication 4, **caractérisé en ce que** l'au moins une membrane (135) est maintenue ou serrée entre l'élément d'étanchéité à lèvres (115) et le fond (150) de l'alésage de trou borgne.

6. Boîtier selon l'une quelconque des revendications précédentes, **caractérisé en ce que** l'au moins une membrane (135) est maintenue ou serrée entre l'élément d'étanchéité à lèvres (115) et l'élément de retenue (155).

7. Boîtier selon l'une quelconque des revendications précédentes, **caractérisé en ce que** l'élément d'étanchéité à lèvres (115) est divisé axialement en au moins deux parties d'élément d'étanchéité à lèvres, et l'au moins une membrane (135) est serrée axialement entre les deux parties d'élément d'étanchéité à lèvres.

8. Boîtier selon l'une quelconque des revendications précédentes, **caractérisé en ce que** l'au moins une membrane (135) est reliée de manière inamovible ou amovible à l'élément d'étanchéité à lèvres (115).

9. Boîtier selon l'une quelconque de la revendication 8, **caractérisé en ce que** l'au moins une membrane (135) présente un anneau porteur radialement extérieur qui est relié de manière inamovible ou amovible à l'élément d'étanchéité à lèvres (115).

10. Boîtier selon la revendication 8 ou 9, **caractérisé en ce que** l'au moins un bord radialement extérieur de l'au moins une membrane (135) est vulcanisé dans l'élément d'étanchéité à lèvres (115) composé en matériau élastomère.

11. Boîtier selon la revendication 8 ou 9, **caractérisé en ce que** l'au moins une membrane (135) est reliée à l'élément d'étanchéité à lèvres (115) par collage.

12. Boîtier selon l'une quelconque des revendications précédentes, **caractérisé en ce que** l'au moins une membrane (135) se compose d'au moins une couche de membrane ou est formée par une partie composite d'au moins une couche de membrane et d'au moins une couche de non-tissé.

13. Boîtier selon la revendication 12, **caractérisé en ce que** l'au moins une couche de membrane se compose de polytétrafluoroéthylène (PTFE) ou de fluorure de polyvinylidène (PVDF).

14. Boîtier selon l'une quelconque des revendications précédentes, **caractérisé en ce que** l'au moins une lèvre d'étanchéité flexible de l'élément d'étanchéité à lèvres (115) est formée de manière périphérique au niveau du corps de base.

15. Boîtier selon l'une quelconque des revendications précédentes, **caractérisé en ce que** la soupape de décharge est formée afin de permettre certes un écoulement de l'espace intérieur (200) dans l'environnement (300) mais d'empêcher un écoulement de l'environnement (300) dans l'espace intérieur (200).

16. Boîtier selon la revendication 15, **caractérisé en ce que** l'au moins une lèvre d'étanchéité flexible de l'élément d'étanchéité à lèvres (115) dépasse du corps de base (125) selon un angle aigu en direction de l'environnement (300).

17. Boîtier selon l'une quelconque des revendications précédentes, **caractérisé en ce qu'**il est le boîtier d'un appareil électronique ou électropneumatique d'un véhicule.
